# FASCICULE DE BREVET EUROPEEN

(11) **EP 2 391 012 B1**
(45) Date de publication et mention de la délivrance du brevet: **15.08.2018**
(21) Numéro de dépôt: 11167106.1
(22) Date de dépôt: 23.05.2011
(51) Int. Cl.: H03M 1/20, G01S 7/288

(54) **Procédé et dispositif permettant de réaliser le codage analogique-numérique de signaux hyperfréquence de très grande dynamique présentant une grande bande passante.**
Verfahren und Vorrichtung zur Umsetzung der Analog-Digital-Kodierung von Hyperfrequenzsignalen mit sehr großer Dynamik, die eine große Bandbreite aufweisen
Method and device for analogue-to-digital encoding of hyperfrequency signals with very high dynamics having large bandwidth.

(30) Priorité: 28.05.2010 FR 1002268
(43) Date de publication de la demande: 30.11.2011
(73) Titulaire: Thales, 92400 Courbevoie (FR)
(72) Inventeur: Garrec, Patrick, 33700 MERIGNAC (FR); Cornic, Pascal, 29200 BREST (FR); Kemkemian, Stéphane, 75014 PARIS (FR)
(74) Mandataire: Lucas, Laurent Jacques

(56) Documents cités:
- FR-A1- 2 719 669
- MOYER L R ET AL: "ANALOG CLUTTER CANCELLATION ALGORITHMS FOR DYNAMIC RANGE REDUCTION", IEEE AEROSPACE AND ELECTRONIC SYSTEMS MAGAZINE, IEEE SERVICE CENTER, PISCATAWAY, NJ, US, vol. 8, no. 10, 1 octobre 1993 (1993-10-01), pages 10-14, XP000413523, ISSN: 0885-8985, DOI: 10.1109/62.240101

## Description

La présente invention concerne le domaine général de la réception radar. Il concerne plus particulièrement le codage de signaux hyperfréquence de très grande dynamique, présentant une large bande passante, au moyen de convertisseurs analogique-numériques.

Il est généralement convenu que, pour pouvoir coder toute la dynamique utile de signaux à très grande dynamique, il faut des codeurs réalisant une conversion analogique numérique sur un nombre de bit important. Plusieurs technologies connues permettent de réaliser ce type de codeurs. On distingue ainsi, les codeurs des codeurs flash, les codeurs à approximation successives, les codeurs sigma-delta, ou encore les codeurs à extrapolation.

Il est connu de numériser des signaux analogiques en mettant en oeuvre des méthodes de conversion récursives (par approximations successives). Dans de telles méthodes, on associe au codeur, en amont de celui-ci, un échantillonneur-bloqueur de préférence de très bonne qualité qui maintient le signal échantillonné pendant toute la durée de la conversion analogique-numérique. De la sorte, le signal analogique étant pour ainsi dire mémorisé, il est avantageusement possible d'utiliser des dispositifs de conversion analogique numérique relativement lents. En revanche, la qualité du codage réalisé est fortement tributaire de la qualité de l'échantillonneur bloqueur qui doit être en mesure de garantir le maintien du signal échantillonné pendant toute la durée de la conversion analogique-numérique. De plus la fréquence du signal échantillonné est ici tributaire du temps nécessaire pour réaliser les conversions successives.

Une solution connue pour remédier à ces inconvénients consiste à mettre en place plusieurs voies de codage parallèles et à réaliser le multiplexage temporel des signaux numériques produits. Cependant la mise en oeuvre de telles méthodes nécessite, par principe l'utilisation d'une pluralité de lignes d'échantillonnage et de codage fonctionnant en parallèle, ainsi que d'un système de distribution du signal sur les différentes lignes. Elles conduisent donc à la mise en place de systèmes plus encombrants et plus couteux.

Il est également connu de numériser des signaux analogiques en mettant en oeuvre des méthodes de conversion par codage Sigma-Delta. Ces méthodes consistent à appliquer au signal analogique un processus itératif consistant à calculer à chaque itération l'intégrale de la différence codée sur 1 bit entre le signal analogique d'entrée et le signal analogique représentant l'intégrale de la différence calculée à l'itération précédente. Par suite, au bout de quelques itérations, un signal numérique effectif est produit à chaque itération en intégrant l'erreur, quantifiée sur deux états "0" ou "1", entre le signal numérique produit à l'itération précédente et le signal entrant.

Une telle méthode de codage permet avantageusement de réaliser un codage efficace tout en utilisant des convertisseurs de relativement faible dynamique. En revanche dans la mesure où le signal numérisé doit finalement être reconstruit par mesures de différences successives, sa reconstruction est parfois délicate et prend un certain temps.

Dans une version alternative, le codage Sigma-Delta peut consister à utiliser un échantillonneur bloqueur et à faire un codage grossier en poids forts du signal entrant de le convertir en analogique et de le soustraire au signal bloqué. La différence est ensuite codée à son tour et un recalage des dynamiques est appliqué pour reconstituer le signal résultant.

Il est encore connu qu'une numérisation rapide de signaux analogiques peut être réalisée en mettant en oeuvre des convertisseurs flash. La conversion est alors réalisée en une seule fois en comparant te signal analogique à 2^{N}-1 tensions de référence internes en progression arithmétique de raison Vₘₐₓ/N. De tels procédés quoique efficaces sont néanmoins encore limités du point de vue de la dynamique de codage du signal, en particulier lorsqu'il s'agit de coder des signaux de très haute fréquence et à grande dynamique.

La publication IEEE Aerospace and Electronic Systems Magazine du 8/10/1993 N°10 enseigne une technique permettant de réduire la plage dynamique du signal d'entrée d'un récepteur radar avant la numérisation. La réduction de la portée dynamique est accomplie à travers un processus qui prédit le signal radar de retour suivant à partir des signaux de retour précédents, génère une forme d'onde de réplique, et soustrait cette forme d'onde de réplique du signal radar de retour avant la numérisation. Ce processus permet au signal radar de retour d'être numérisé sans distorsion par un Convertisseur Analogique Numérique (CAN) ayant une plage dynamique limitée. La gamme dynamique du signal radar de retour est alors restaurée en ajoutant forme d'onde de réplique à la sortie CAN.

Un but de l'invention est de proposer une solution permettant de réaliser la conversion analogique-numérique, ou autrement dit le codage, de signaux à haute fréquence, ou à large spectre, présentant une grande dynamique.

Un but de l'invention est donc de permettre un codage performant des signaux stationnaires ou dit "fixes" et des échos fluctuants ou dit "mobiles" sans nécessiter un codeur possédant la dynamique totale normalement nécessaire pour numériser la somme des deux signaux. Autrement dit, un but de l'invention est de proposer une solution permettant d'obtenir une image numérique de la somme des signaux considérés qui ne présente pas de perte significative d'information, c'est-à-dire une solution permettant de coder des signaux de forte dynamique en utilisant des convertisseurs analogique-numériques, des codeurs, ne permettant normalement pas d'obtenir la dynamique souhaitée.

A cet effet l'invention a pour objet un dispositif pour réaliser la conversion analogique-numérique d'un signal analogique selon les revendications 1 et 3.

Selon un premier mode de mise en oeuvre particulier, le dispositif selon l'invention comporte au moins:
- des moyens pour réaliser la différence ε(t) entre le signal S(t) a convertir et le signal de retour S'(t);
- des moyens pour réaliser la somme du signal ε(n) produit par des moyens de numérisation à partir du signal ε(t) et le signal S'(n);
- des moyens pour mémoriser, N séquences numériques successives Sₖ(n) du signal S(n);
- des moyens pour générer le signal S'(n) à partir des N séquences successives Sₖ(n) mémorisées;
- des moyens pour produire un signal analogique de retour S'(t) à partir du signal S'(n).

Selon un deuxième mode de mise en oeuvre particulier, le dispositif selon l'invention est utilisé dans un dispositif pour réaliser la conversion analogique-numérique d'un signal radioélectrique S(t) en deux signaux numériques en quadrature de phase S_{I}(n) et S_{Q}(n), ledit signal S(t) étant appliqué à un démodulateur amplitude phase produisant deux signaux I(t) et Q(t) en quadrature de phase à partir du signal S(t). Ce dispositif comporte deux dispositifs selon l'invention. Chacun des dispositifs réalise la conversion du signal I(t) en un signal numérique S_{I}(n) ou la conversion du signal Q(t) en un signal numérique S_{Q}(n).

Selon un troisième mode de mise en oeuvre particulier, adapté à la conversion d'un signal S(t) radioélectrique dont la conversion analogique-numérique est réalisée en deux signaux numériques en quadrature de phase S_{I}(n) et S_{Q}(n), le dispositif comporte:
- des moyens pour produire un signal de fréquence intermédiaire à partir de signaux S'_{I}(n) et S'_{Q}(n) formés à partir de N séquences successives S_{kI} (n) et S_{kQ} (n) des signaux S_{I}(n) et S_{Q}(n).
- des moyens pour réaliser la différence entre le signal S(t) a convertir et le signal de retour S'(t), le signal S'(t) étant un signal radioélectrique;
- des moyens pour réaliser une détection amplitude-phase du signal ε(t) et former deux signaux en bande de base ε_{I}(t) et ε_{Q}(t), en quadrature de phase,
- deux voies de numérisation délivrant les signaux S_{I}(n) et S_{Q}(n) et comportant chacune
   - des moyens pour réaliser la somme des signaux ε_{I}(n) et ε_{Q}(n) produits par des moyens de numérisation à partir des signaux ε_{I}(t) et ε_{Q}(t) et des signaux S'_{I}(n) et S'_{Q}(n);
   - des moyens pour mémoriser pour chacun des signaux S_{I}(n) et S_{Q}(n), N séquences numériques successives S_{kI}(n) et S_{kQ}(n).

Selon un quatrième mode de mise en oeuvre particulier, également adapté à la conversion d'un signal S(t) radioélectrique dont la conversion analogique-numérique est réalisée en deux signaux numériques en quadrature de phase S_{I}(n) et S_{Q}(n), le dispositif comporte:
- des moyens pour produire deux signaux numériques I_{log}(n) et Q_{log}(n) en quadrature de phase à partir du signal S(t) par numérisation des signaux I_{log}(t) et Q_{log}(t) obtenus par amplification logarithmique et détection amplitude-phase;
- des moyens pour mémoriser pour chacun des signaux I_{log}(n) et Q_{log}(n), N séquences numériques successives I_{klog}(n) et Q_{klog}(n);
- des moyens pour synthétiser des signaux numériques linéaires S'_{I}(n) et S'_{Q}(n) en quadrature de phase à partir des N séquences numériques successives I_{klog}(n) et Q_{klog}(n);
- des moyens pour produire un signal de retour S'(t) en fréquence intermédiaire à partir de signaux S'_{I}(n) et S'_{Q}(n);
- des moyens pour réaliser la différence entre le signal S(t) a convertir et le signal de retour S'(t), le signal S'(t) étant un signal radioélectrique;
- des moyens pour réaliser une détection amplitude-phase du signal ε(t) et former deux signaux en bande de base ε_{I}(t) et ε_{Q}(t), en quadrature de phase,
- deux voies de numérisation comportant chacune des moyens pour réaliser la somme des signaux ε_{I}(n) et ε_{Q}(n) produits par des moyens de numérisation à partir des signaux ε_{I}(t) et ε_{Q}(t) et des signaux S'_{I}(n) et S'_{Q}(n), les voies de numérisation délivrant les signaux S_{I}(n) et S_{Q}(n);

Selon un cinquième mode de mise en oeuvre particulier, également adapté à la conversion d'un signal S(t) radioélectrique dont la conversion analogique-numérique est réalisée en deux signaux numériques en quadrature de phase S_{I}(n) et S_{Q}(n), le dispositif comporte:
- des moyens pour produire deux signaux numériques I'(n) et Q'(n) en quadrature de phase à partir du signal S(t) par numérisation des signaux I'(t) et Q'(t) obtenus par amplification et écrêtage du signal S(t) puis détection amplitude-phase;
- des moyens pour produire un signal numérique S_{log}(n) et à partir du signal S(t) par numérisation du signal S_{log}(t) obtenu par amplification logarithmique et détection d'amplitude du signal S(t);
- des moyens pour mémoriser pour chacun des signaux I'(n), Q'(n) et S_{log}(n), N séquences numériques successives I'ₖ (n), Q'ₖ(n) et S_{klog}(n);
- des moyens pour synthétiser des signaux numériques linéaires S'_{I}(n) et S'Q(n) en quadrature de phase à partir des N séquences numériques successives I'ₖ(n), Q'ₖ(n) et S_{klog}(n);
- des moyens pour produire un signal de retour S'(t) en fréquence intermédiaire à partir de signaux S'_{I}(n) et S'_{Q}(n);
- des moyens pour réaliser la différence entre le signal S(t) a convertir et le signal de retour S'(t), le signal S'(t) étant un signal radioélectrique;
- des moyens pour réaliser une détection amplitude-phase du signal ε(t) et former deux signaux en bande de base ε_{I}(t) et ε_{Q}(t), en quadrature de phase,
- deux voies de numérisation comportant chacune des moyens pour réaliser la somme des signaux ε_{I}(n) et ε_{Q}(n) produits par des moyens de numérisation à partir des signaux ε_{I}(t) et ε_{Q}(t) et des signaux S'_{I}(n) et S'_{Q}(n), les voies de numérisation délivrant les signaux S_{I}(n) et S_{Q}(n);

Selon une forme de réalisation particulière, applicable à différents modes de mise en oeuvre, les moyens pour produire un signal de retour S'(t) en fréquence intermédiaire à partir de signaux S'_{I}(n) et S'_{Q}(n) comportent:
- des moyens pour générer à partir d'un oscillateur local un signal S'(t) d'amplitude et de phase données;
- des moyens pour générer des signaux de commande permettant de contrôler l'amplitude et la phase du signal S'(t) généré;

Les signaux de commande générés étant fonctions des signaux S'_{I}(n) et S'_{Q}(n).

Selon une première variante de la forme de réalisation particulière précédente, les moyens pour générer le signal S'(t) à partir d'un oscillateur local comportent un amplificateur à gain variable et un circuit déphaseur.

Selon une autre variante de la forme de réalisation particulière précédente, les moyens pour générer le signal S'(t) à partir d'un oscillateur local comportent un circuit de synthèse directe de fréquence.

Selon une variante du quatrième mode de mise en oeuvre particulier:
- les deux voies de numérisation sont configurées pour délivrer les signaux ε_{I}(n) et ε_{Q}(n). Elles comportent des moyens pour mémoriser la séquences numériques ε_{1I}(n) ou ε_{1Q}(n) correspondant à l'intervalle de temps précédant l'intervalle de temps courant;
- les moyens de mémorisation associés aux moyens pour produire deux signaux numériques I_{log}(n) et Q_{log}(n) en quadrature de phase à partir du signal S(t) sont configurés pour mémoriser une séquences numériques I_{1log}(n) ou Q_{1log}(n) correspondant à l'intervalle de temps précédant l'intervalle de temps courant. Les moyens pour synthétiser des signaux numériques linéaires S'_{I}(n) et S'_{Q}(n) en quadrature de phase sont quant à eux configurés pour synthétiser S'_{I}(n) et S'_{Q}(n) à partir des séquences numériques I_{1log}(n) et Q_{1log}(n) et des séquences ε_{1I}(n) et ε_{1Q}(n), de sorte que le signal S'(t) synthétisé à partir de S'_{I}(n) et S'_{Q}(n) corresponde S(t-T).

Selon une autre variante du quatrième mode de mise en oeuvre particulier, les moyens de mémorisation associés aux moyens pour produire deux signaux numériques I_{log}(n) et Q_{log}(n) en quadrature de phase à partir du signal S(t) sont configurés pour mémoriser deux séquences numériques successives I_{1log}(n) ou Q_{1log}(n) et I_{2log}(n) ou Q_{2log}(n) correspondant au deux intervalles de temps successif précédant l'intervalle de temps courant. Les moyens pour synthétiser des signaux numériques linéaires S'_{I}(n) et S'_{Q}(n) en quadrature de phase sont quant à eux configurés pour synthétiser S'_{I}(n) et S'_{Q}(n) à partir des séquences numériques I_{1log}(n) et Q_{1log}(n) et des séquences I_{2log}(n) et Q_{2log}(n)).

Selon une forme de réalisation particulière de la variante de réalisation précédente, les deux voies de numérisation sont configurées pour délivrer les signaux ε_{I}(n) et ε_{Q}(n). Elles comportent en outre:
- des moyens pour mémoriser la séquences numériques ε_{1I}(n) ou ε_{1Q}(n) correspondant à l'intervalle de temps précédant l'intervalle de temps courant;
- des moyens pour réaliser la somme du signal I_{1log}(n) avec le signal ε_{1I}(n) et la somme du signal Q_{1log}(n) avec le signal ε_{1Q}(n); les moyens pour synthétiser des signaux numériques linéaires S'_{I}(n) et S'_{Q}(n) en quadrature de phase sont configurés pour synthétiser S'_{I}(n) et S'_{Q}(n) à partir des séquences numériques I_{1log}(n) + ε_{1I}(n) et Q_{1log}(n) + ε_{1Q}(n) et des séquences I_{2log}(n) et Q_{2log}(n)).

Selon un autre mode de mise en oeuvre particulier, adapté à la conversion d'un signal S(t) hyperfréquence, il comporte au moins:
- des moyens pour réaliser en hyperfréquence la différence ε(t) entre le signal S(t) à convertir et le signal de retour S'(t) transposé en hyperfréquence;
- des moyens pour réaliser la somme du signal ε(n) produit par des moyens de numérisation à partir du signal ε(t) et le signal S'(n);
- des moyens pour mémoriser, N séquences numériques successives Sₖ(n) du signal S(n);
- des moyens pour générer le signal S'(n) à partir des N séquences successives Sₖ(n) mémorisées;
- des moyens pour produire un signal analogique de retour S'(t) à partir du signal S'(n);
- des moyens pour assurer la transposition du signal S'(t) en un signal hyperfréquence S'ₕ(t).

L'invention permet avantageusement de réaliser un codage analogique numérique rapide de signaux de grande dynamique, pour peu que les signaux codés aient une stationnarité suffisante. C'est le cas notamment des signaux non fluctuants de forte amplitude, ou des signaux composites constitués d'une composante non fluctuante de forte amplitude associée à au moins une composante fluctuante de plus faible amplitude.

Elle peut avantageusement être implantée sur des équipements existants sans modifier de manière importante la structure de ces équipements. Elle ne nécessite en particulier pas de remplacer les codeurs déjà montés sur les équipements modifiés.

Les caractéristiques et avantages de l'invention seront mieux appréciés grâce à la description qui suit, qui présente les caractéristiques du dispositif selon l'invention au travers de différents modes de réalisations présentés à titre d'exemples de réalisation non limitatifs ainsi qu'au travers d'applications également décrites à titre d'exemples. Cette description s'appuie sur les figures annexées qui représentent:
- la figure1, une illustration de la structure de base du dispositif de codage analogique-numérique selon l'invention;
- la figure 2, le synoptique de principe d'un premier mode de réalisation du dispositif selon l'invention dans le cadre d'un exemple d'application à la numérisation d'un signal radar en bande de base sous forme de deux signaux en quadrature de phase;
- la figure 3, le synoptique de principe d'un deuxième mode de réalisation du dispositif selon l'invention dans le cadre d'un exemple d'application à la numérisation d'un signal radar en en fréquence intermédiaire sous forme de deux signaux en quadrature de phase;
- la figure 4, le synoptique de principe d'un troisième mode de réalisation du dispositif selon l'invention dans le même cadre d'application que celui de la figure 3;
- la figure 5, le synoptique de principe d'un quatrième mode de réalisation du dispositif selon l'invention dans le même cadre d'application que celui des figures 3 et 4;
- La figure 6, le synoptique de principe d'une variante du mode de réalisation de la figure 5;
- les figures 7 et 8, les synoptiques de principe de deux applications du dispositif de codage selon l'invention constituant des variantes de réalisation du mode de la figure 4 les applications portant, dans le contexte du traitement d'un signal radar, sur le filtrage des échos fixes ou faiblement mobiles;
- la figure 9, le synoptique de principe d'un cinquième mode de réalisation du dispositif selon l'invention dans le cadre d'un exemple d'application à la numérisation d'un signal radar en hyper fréquence.

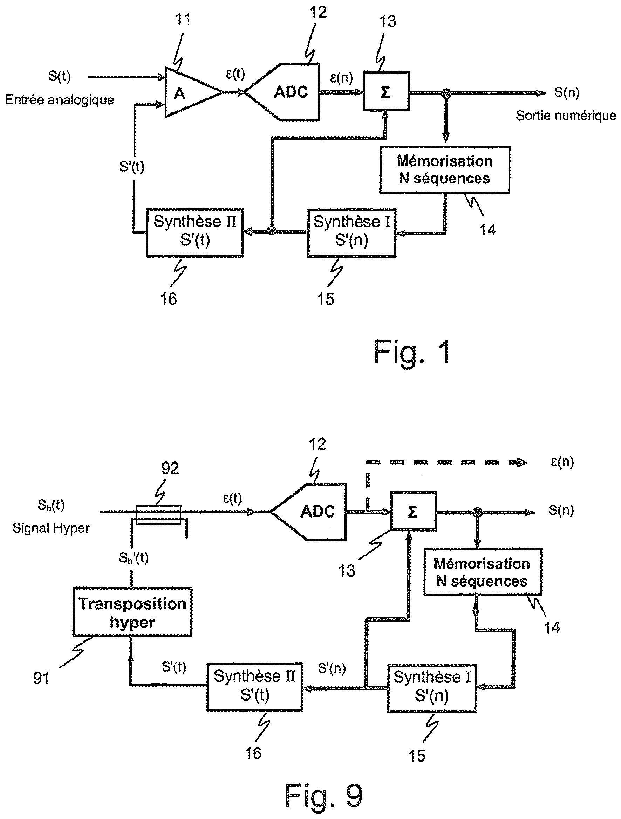

On considère dans un premier temps la figure 1 qui présente un synoptique schématique de la structure générale du dispositif selon l'invention.

Comme il a été dit précédemment, le dispositif selon l'invention trouve son application dans la numérisation d'un signal présentant une certaine stationnarité, c'est-à-dire un signal S(t) tel que pour un intervalle de temps T donné, on a pour un nombre significatif N d'intervalles de temps successifs, S(t) = S(t-T) = S(t-2T) = ... = S(t-NT). Par suite le dispositif selon l'invention réalise la conversion analogique-numérique du signal S(t), ou plus exactement des séquences successives du signal S(t) de durée T, sous la forme d'un signal numérique S(n) constitué de séquences numériques successives de P échantillons, S₁(n), S₂(n), ..., S_{N}(n), P étant sensiblement égal à T/Tₑ, Tₑ représentant la fréquence d'échantillonnage du dispositif.

Un tel signal est par exemple le signal reçu par un récepteur réalisant de manière synchrone la réception d'un signal radioélectrique dans une direction donnée durant plusieurs intervalles de temps successifs, un récepteur radar effectuant la réception du signal réfléchi correspondant aux récurrences successives formant une même rafale par exemple. S(t) est alors un signal constitué de séquences temporelles successives de durée T chaque séquence correspondant à une récurrence d'émission, chaque instant t d'un intervalle de temps correspondant à un point donné de l'axe distance du radar identique d'un intervalle à l'autre; la fréquence d'échantillonnage Tₑ correspondant quant à elle au pas d'échantillonnage en distance.

Autrement dit, le dispositif selon l'invention tire parti du caractère stationnaire du signal traité pour associer des échantillons de signal correspondant à des instants équivalents de différentes périodes d'acquisition du signal S(t) que l'on souhaite numériser. L'association n'est donc pas une association d'instants à l'intérieur d'un intervalle donné mais une association d'instants d'intervalle de temps à intervalle de temps, la limite étant ici donnée par la durée pour laquelle le signal S(t) peut être considéré comme stationnaire.

Le procédé de codage mis en oeuvre par le dispositif selon l'invention est un procédé itératif consistant à réaliser, pour chaque intervalle de temps T non pas le codage de la séquence du signal entrant s(t) correspondante, mais de la séquence constituée par la différence ε(t) entre le signal d'entrée S(t) et un signal de retour S'(t). Selon l'invention, S'(t) est une estimation du signal S(t) réalisée à partir de séquences d'acquisition successives de signal S(t) pour des intervalles de temps d'acquisition successifs précédant l'intervalle de temps considéré.

Dans un mode de réalisation préféré, ces séquences sont exploitées sous forme numérique et sont combinées de façon à produire une séquence S'(t) aussi semblable que possible de la séquence du signal S(t) correspondant à l'intervalle de temps précédent l'intervalle de temps courant. Le signal ε(t) correspond ainsi sensiblement à la différence S(t) - S(t-T).

Cependant dans des formes de réalisation alternatives Le signal S'(t) produit peut représenter une fonction, une combinaison pondérée ou une extrapolation par exemple, des différentes séquences du signal S(t) correspondant à plusieurs intervalles de temps successifs précédent l'intervalle de temps courant.

Dans une forme de base de l'invention, le signal S(t) numérisé est un signal analogique en bande de base, un signal vidéo par exemple. Un tel signal peut par exemple correspondre à un signal radioélectrique transposé en bande de base, un signal radar transposé en bande de base au moyen d'un oscillateur FI local par exemple.

Dans cette forme de base de l'invention, le signal de retour S'(t) est produit par des seconds moyens de synthèse appropriés 16 (synthèse d'un signal analogique) à partir de la séquence numérique S₁(n) correspondant au signal produit par le dispositif pour l'intervalle de temps T qui précède l'intervalle de temps considéré. La structure des seconds moyens 16 pour produire S'(t) varie avec le mode de réalisation du dispositif. Cependant, dans une forme simple, ces moyens peuvent par exemple simplement consister en un convertisseur réalisant la conversion numérique-analogique du signal S₁(n).

Plus généralement, comme illustré par la figure 1, le signal S'(t) peut être produit à partir d'une pluralité de séquences numériques Sₖ(n), successives dans le temps et combinées par des premiers moyens de synthèse appropriés 15 (synthèse d'un signal numérique) en un signal S'(n) à partir duquel le signal S'(t) est produit, par conversion numérique-analogique par exemple.

Dans sa forme générale, le dispositif comporte ainsi des moyens 11 pour effectuer la différence ε(t) entre s(t) et s'(t), et des moyens 12 pour la numériser cette différence ε(t). Il comporte également des moyens 13 pour réaliser la somme de la différence numérisée ε(n) et du signal S'(n), ainsi que des moyens 14 pour mémoriser des séquences successives du signal produit et des premiers moyens de synthèse 15 pour effectuer la conversion numérique-analogique du signal S'(n).

Ainsi, dans une forme de base du dispositif selon l'invention, la séquence du signal S(n) produite durant l'intervalle de temps courant est ainsi la somme du signal correspondant à la différence ε(t) numérisée et de la séquence S₁(n) mémorisée durant l'intervalle de temps précédant l'instant courant. La valeur S(n) du signal produit, est donc actualisée, d'une période à l'autre, par la différence entre la séquence S_{I}(n) convertie en signal analogique et la valeur du signal d'entré s(t) pour l'intervalle de temps considéré.

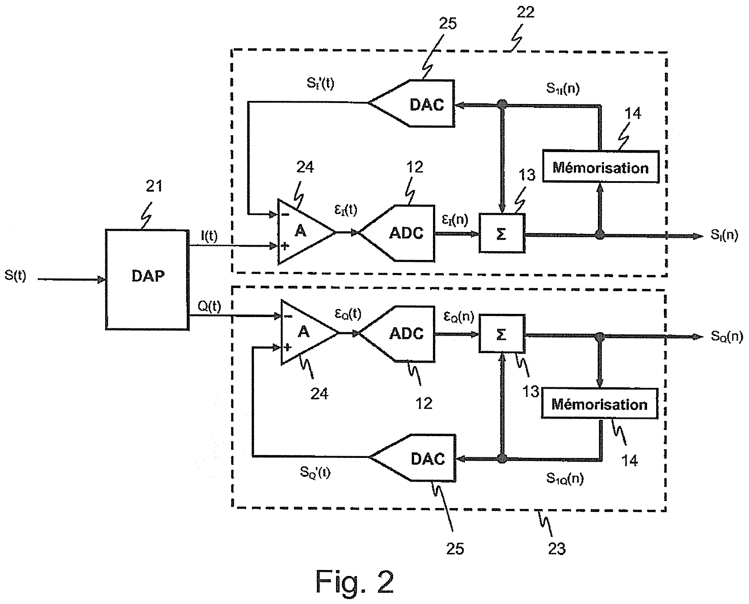

Un premier exemple de réalisation du dispositif selon l'invention, est illustré par la figure 2. Il consiste à appliquer le dispositif selon l'invention dans le contexte d'une chaine de réception double d'un signal hyperfréquence. La chaine comporte ici un dispositif connu 21 de démodulation amplitude-phase délivrant, à partir d'un signal hyperfréquence transposé en fréquence intermédiaire S(t), deux signaux I(t) et Q(t) en bande de base, en quadrature de phase l'un par rapport à l'autre. On rappelle à ce propos qu'une telle démodulation permet de conserver l'information de phase portée par le signal démodulé. Cette information de phase est définie par rapport à une phase de référence donnée.

Dans cet exemple, le dispositif selon l'invention comporte deux chaines de numérisation identiques 22 et 23, une pour chacun des deux signaux I(t) et Q(t). Chaque chaine est constituée par un dispositif selon l'invention, de structure semblable à celle illustrée par la figure 1. Elle produit, à partir d'un des deux signaux en quadratures I(t) et Q(t) délivrés par le détecteur amplitude-phase 21, deux signaux numérisés sous la forme de séquences S_{I}(n) et S_{Q}(n). Le principe mis en oeuvre par chacun des dispositifs 22 et 23 est identique à celui du dispositif de principe de la figure 1. Un signal différence ε_{I}(t), ou ε_{Q}(t), distinct pour chaque dispositif, est ici formé en effectuant la différence entre un des signaux I(t) et Q(t) et le signal S'_{I}(t) ou S'_{Q}(t) correspondant à la conversion numérique-analogique du signal S'_{I}(n) = S_{1I}(n) ou S'_{Q}(n) = S_{1Q}(n). La formation du signal d'erreur ε_{I}(t), ou ε_{Q}(t), est réalisée au moyen d'un amplificateur différentiel 24 fonctionnant en bande de base.

Il est à noter ici que comme dans le cas de la configuration générale décrite précédemment, cet exemple de réalisation peut être adapté de façon à ce que les signaux S'_{I}(n) et S'_{Q}(n) correspondent non plus aux séquences S_{1I}(n) et S_{1Q}(n) mais à des combinaisons de N séquences successives S_{kI}(n) et S_{kQ}(n), les moyens de mémorisation 14 étant alors dimensionnés et configurés en conséquence. Chaque dispositif 22 ou 23 comporte alors également des moyens pour synthétiser les signaux S'_{I}(n) et S'_{Q}(n) au moyen des différentes séquences S_{kI}(n) et S_{kQ}(n).

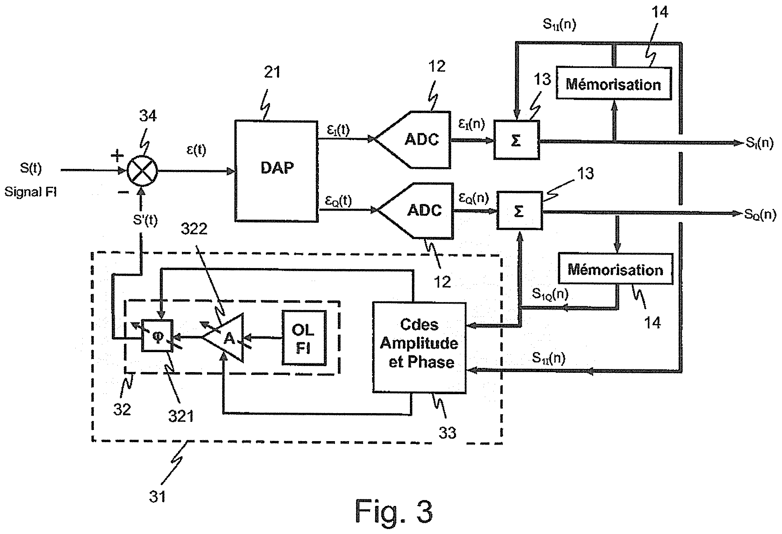

Un deuxième exemple de réalisation du dispositif selon l'invention est illustré par la figure 3. A la différence du précédent en ce que les deux dispositifs pour numériser le signal S(t) en deux signaux S_{I}(n) et S_{Q}(n) comporte des moyens communs 31 pour synthétiser, en fréquence intermédiaire, un signal de retour S'(t) commun. Le signal S'(t) formé est soustrait au signal à numériser S(t) avant la détection amplitude phase 21; de sorte que le détecteur amplitude phase 21 produit directement deux signaux d'erreur en quadrature de phase ε_{I}(t) et ε_{Q}(t).

Dérivé du mode de réalisation précédent illustré par la figure 2, ce mode de réalisation a pour avantage d'éviter l'utilisation d'un amplificateur différentiel pour produire les signaux d'erreurs ε_{I}(t) ou ε_{Q}(t). Les moyens 34 pour réaliser, en fréquence intermédiaire, la différence ε(t) entre les signaux S(t) et S'(t) présentant une dynamique plus élevée que les amplificateurs différentiels généralement utilisés dans le mode de réalisation de la figure 2. La dynamique de codage accessible se trouve ainsi avantageusement augmentée.

Selon l'invention, les moyens 31 pour synthétiser le signal de retour S'(t) comportent des moyens 32 pour synthétiser, à partir d'un oscillateur de référence, un oscillateur local utilisé pour la démodulation amplitude-phase de ε(t) par exemple, un signal en fréquence intermédiaire commandable en amplitude et en phase; ainsi que des moyens 33 pour synthétiser les commandes d'amplitude et de phases appropriées à partir des signaux numériques S_{I}(n) et S_{Q}(n) précédant l'intervalle de temps T considéré. La synthèse de commandes permettant de produire le signal S'(t) ayant l'amplitude et la phase adéquate est donc ici substituée à la synthèse réelle d'un signal S'(n).

Il est encore à noter ici que, comme dans le cas de l'exemple précédent, cet exemple de réalisation peut être adapté de façon à ce que la synthèse des commandes d'amplitude et de phase ne soit pas seulement réalisée à partir des séquences S_{1I}(n) et S_{1Q}(n), mais à partir des combinaisons de N séquences successives S_{kI}(n) et S_{kQ}(n), N séquences prédictives éventuellement, les moyens de mémorisation 14, ainsi que le circuit de synthèse des commandes d'amplitude et de phase 33 étant alors dimensionnés et configurés en conséquence.

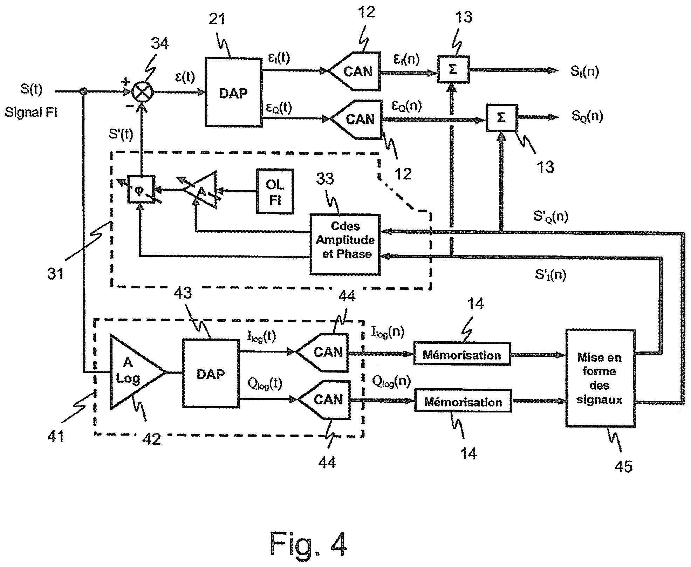

Un troisième exemple de réalisation est illustré par la figure 4. Dans cet exemple comme dans le précédent, le signal de retour S'(t) est synthétisé en fréquence intermédiaire par les moyens de synthèse 31. En revanche à la différence de l'exemple précédent, les signaux de commande d'amplitude et de phase ne sont pas synthétisés à partir des séquences S_{1I}(n) et S_{1Q}(n) (ou de N séquences S_{kI}(n) et S_{kQ}(n)), mais à partir de séquences S'_{I}(n) et S'_{Q}(n) formés, à partir du signal entrant S(t) durant l'intervalle de temps précédent l'intervalle de temps considéré, par une voie 41 de démodulation amplitude-phase et de numérisation complémentaire. De la sorte le signal de retour S'(t) est, de manière avantageuse, directement synthétisé à partir de la séquence temporelle constituant le signal entrant S(t) pour l'intervalle de temps précédant l'intervalle de temps courant et non pas à partir des séquences reconstituées S_{1I}(n) et S_{1Q}(n). De même les signaux de sortie S_{I}(n) et S_{Q}(n) sont produits à partir des séquences S'_{I}(n) et S'_{Q}(n) et non à partir des séquences S_{1I}(n) et S_{1Q}(n).

Selon l'invention la voie complémentaire 41 est une voie "log" pour laquelle la dynamique du signal reçu S(t) est d'abord adaptée par un amplificateur logarithmique 42. Le signal obtenu fait ensuite l'objet d'une détection amplitude phase 43 délivrant deux signaux I_{log}(t) et Q_{log}(t) qui font l'objet chacun d'une numérisation 44 produisant les signaux L_{log}(n) et Q_{log}(n) qui sont mémorisés pendant un (ou plusieurs) intervalle(s) de temps T dans des circuits mémoires 14. Les signaux I_{log}(n) et Q_{log}(n) délivrés par les mémoires sont ensuite transmis avec un retard T à un circuit 45, dont le rôle est de restituer des signaux linéaires S'_{I}(n) et S'_{Q}(n) qui sont transmis aux moyens de synthèse 31, moyens qui par ailleurs peuvent rester inchangés par rapport à l'exemple de réalisation illustré par la figure 3.

Il est à noter ici que l'utilisation d'un amplificateur logarithmique permet avantageusement de limiter la dynamique des signaux I_{log}(t) et Q_{log}(t) et la dynamique de codage nécessaire pour numériser ces signaux. Il est ainsi possible d'utiliser des convertisseurs analogiques-numériques 44 de dynamique standard, sans risquer de dégrader la numérisation des signaux I_{log}(t) et Q_{log}(t). La probabilité de saturation et donc d'écrêtage des signaux est ainsi minimisée, la plage de dynamique utile des signaux étant très grande.

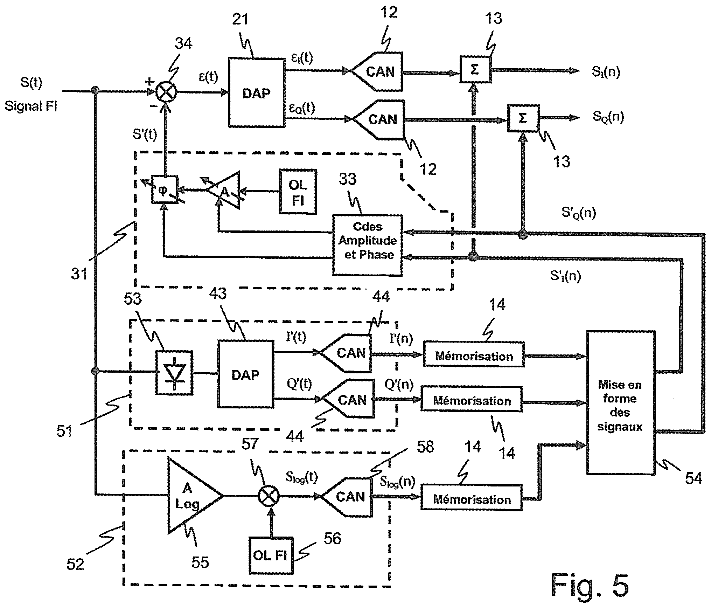

Un quatrième exemple de réalisation, est illustré par la figure 5. Comme pour l'exemple de réalisation précédent, les signaux de commande d'amplitude et de phase sont synthétisés à partir des signaux S'_{I}(n) et S'_{Q}(n) formés, à partir du signal entrant S(t), par une voie 51 de démodulation amplitude-phase et de numérisation complémentaire. De la sorte le signal de retour S'(t) est, de manière avantageuse, directement synthétisé à partir de la séquence temporelle constituant le signal entrant S(t) pour l'intervalle de temps précédant l'intervalle de temps courant considéré. Cependant, à la différence du mode de réalisation précédent, la voie de démodulation amplitude phase est ici utilisée seulement pour coder sous forme numérique l'information de phase du signal d'entrée S(t). Elle est associée à une voie complémentaire 52 destinée quant à elle à coder sous forme numérique l'information d'amplitude de ce signal. Dans une telle configuration, la voie de démodulation amplitude-phase comporte un élément écrêteur 53 dont le rôle est de limiter l'amplitude du signal S(t) sans considération de sa forme de façon toutefois à conserver l'information de phase du signal. La sortie de l'élément 53 est appliquée via le détecteur amplitude-phase 43 à une chaine de numérisation et de mémorisation semblable à celle mise en oeuvre dans la voie de démodulation amplitude phase 41 du mode de mise en oeuvre précédent illustré par la figure 4. Les signaux produits I'_{log}(n) et Q'_{log}(n) sont ensuite mémorisés pendant un (ou plusieurs) intervalle(s) de temps T dans des circuits mémoires 14.

La voie complémentaire 52 est quant à elle constituée d'un amplificateur d'entré 55 destiné à donner une conformation logarithmique au signal d'entrée S(t) et d'une chaine de démodulation en amplitude classique suivie d'une numérisation 58 du signal démodulé S_{log}(t). Le signal numérisé S_{log}(n) est ensuite mémorisé sur un (ou plusieurs) intervalle(s) de temps T dans une des circuits mémoires 14 du dispositif, au même titre que les signaux I'_{log}(n) et Q'_{log}(n).

Dans ce mode de réalisation comme dans le mode précédent, le dispositif selon l'invention comporte par ailleurs un circuit 54, dont le rôle est de restituer, à partir des signaux de mesure de phase du signal d'entrée I'_{log}(n) et Q'_{log}(n) et du signal de mesure d'amplitude S_{log}(n), des signaux linéaires S'_{I}(n) et S'_{Q}(n) qui sont transmis aux moyens 31 de synthèse du signal S'(t).

Il est à noter ici que bien qu'il mette en jeu une voie de traitement complémentaire 52, et que sa structure soit donc plus complexe que celle de l'exemple précédent, cet exemple de réalisation présente néanmoins un intérêt avantageux. Il permet en effet de traiter séparément les mesures d'amplitude et de phase du signal d'entrée de sorte que la numérisation du signal S(t) peut être réalisée plus simplement; la prise en compte de la phase du signal pouvant en particulier être réalisée de manière efficace à partir de signaux codés sur une dynamique relativement plus restreinte à l'aide de convertisseurs standard.

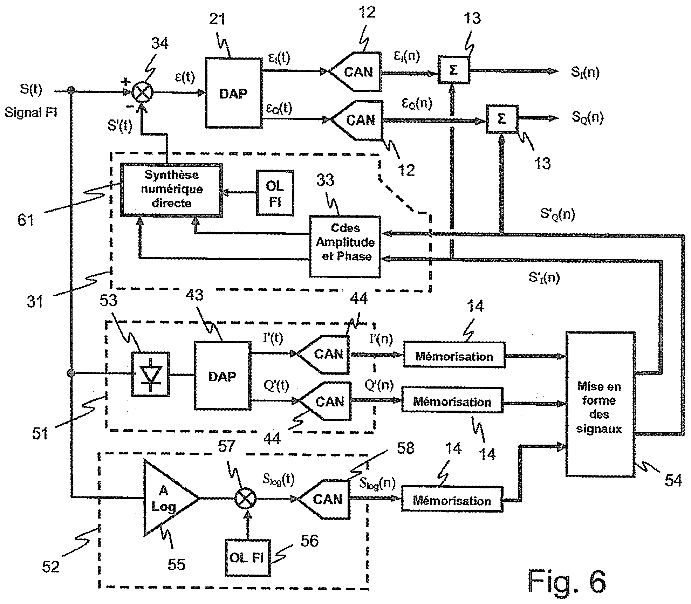

Une variante de réalisation de l'exemple précédent est illustrée par la figure 6. Dans cette variante, qui constitue une alternative de réalisation, les moyens 31 pour synthétiser le signal de retour S'(t) sont constitués par un circuit 61 permettant de réaliser une synthèse numérique directe du signal de retour. Le signal produit est directement déduit de l'oscillateur local et des commandes d'amplitude et de phase délivrées par le circuit 33.

Il est par ailleurs à noter qu'une telle variante est bien entendu applicable aux autres modes de réalisation décrits précédemment et comportant des moyens 31 pour synthétiser le signal de retour S'(t), autrement dit les modes de réalisation illustrés par les figures 3, 4 et 5.

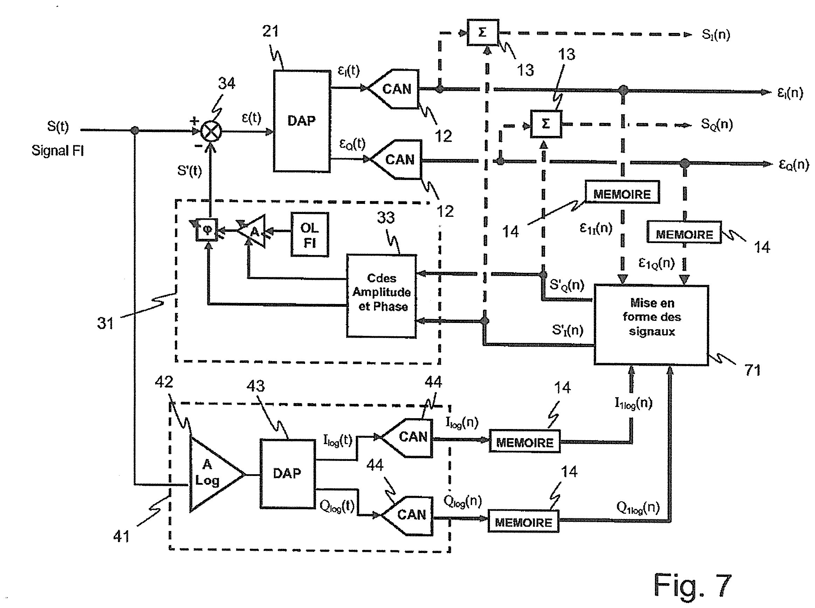

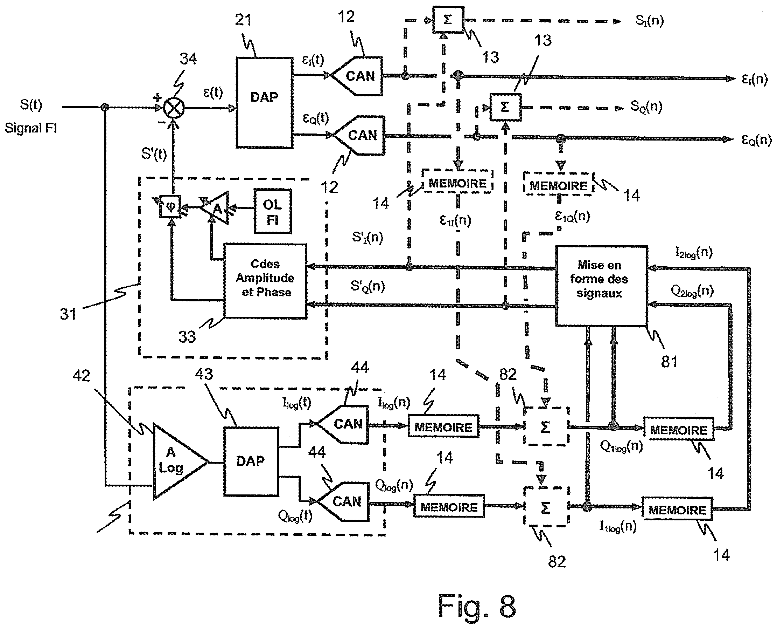

Les figures 7 et 8 présentent deux exemples de réalisation correspondant à des applications particulières de la structure du dispositif selon l'invention dans lesquelles on s'intéresse non pas à la numérisation du signal S(t), numérisation qui reste néanmoins possible comme l'illustre les figures, mais à la numérisation des signaux ε_{I}(t) et ε_{Q}(t). Dans l'exemple de la figure 7 le signal S'(t) est synthétisé de telle façon que les séquences ε_{I}(n) et ε_{Q}(n) correspondent au résultat du filtrage du signal S(t) par un filtre passe-bas du premier ordre; tandis que dans l'exemple de la figure 8 le signal S'(t) est synthétisé de telle façon que les séquences ε_{I}(n) et ε_{Q}(n) correspondent au résultat du filtrage du signal S(t) par un filtre passe-bas du deuxième ordre.

L'exemple de la figure 7 correspond à la réalisation pratique, dans le cas du traitement de signaux radar, d'un filtre permettant de supprimer les échos fixes et faiblement mobiles du signal S(t). L'application illustrée par la figure 7 correspond donc à l'implémentation d'une fonction de type "visualisation des cibles mobiles" ou "MTI" ("Moving Target Indicator" selon la dénomination anglo-saxonne) du premier ordre, au moyen du dispositif selon l'invention.

Le signal de retour S'(t) est ici avantageusement synthétisé à partir d'une voie d'acquisition 41 de type "log", déjà décrite précédemment, associées à des circuits mémoire 14 et à un circuit de mise en forme 71, dont la fonction est de déterminer, à partir des signaux numériques I_{log}(n-1) et Q_{log}(n-1) mémorisés, les signaux numériques S'_{I}(n) et S'_{Q}(n) utilisés par la chaine de synthèse 31 de synthétiser le signal de retour S'(t) désiré. S'(t) correspond ici sensiblement à S(t-T).

Dans un mode préféré de mise en oeuvre, la synthèse des signaux S'_{I}(n) et S'_{Q}(n) par le circuit de mise en forme 71 prend également en compte, non seulement les séquences I_{log}(n) et Q_{log}(n) mémorisées durant l'intervalle de temps (ou plus généralement les intervalles de temps) précédant l'intervalle de temps courant, mais aussi les séquences ε_{I}(n) et ε_{Q}(n) mémorisés durant ce même (ou plus généralement ces mêmes) intervalle de temps. On obtient ainsi un signal de retour qui a déjà subi une première correction, comme dans le cas du mode de réalisation du dispositif selon l'invention illustré par la figure 3.

L'application illustrée par la figure 8 correspond, quant à elle, à l'implémentation d'une fonction de type "visualisation des cibles mobiles" du deuxième ordre, au moyen du dispositif selon l'invention; application dérivée de la précédente.

Dans une version de base, le signal de retour S'(t) est ici synthétisé à partir d'une voie d'acquisition 41 de type "log", déjà décrite précédemment, associées à des circuits mémoire 14 configurés et agencés de façon à ce que les signaux I_{log}(n) et Q_{log}(n) subissent deux retards successifs de façon à produire les séquences I_{1log}(n) et Q_{1log}(n) correspondant à l'intervalle de temps précédant l'intervalle de temps considéré et les séquences I_{2log}(n) et Q_{2log}(n) correspondant à l'intervalle de temps précédant l'intervalle de temps relatif aux séquences I_{1log}(n) et Q_{1log}(n). La voie d'acquisition 41 est également associée à un circuit de mise en forme 81 dont la fonction est de déterminer, à partir des séquences numériques I_{1log}(n) et Q_{1log}(n) et des séquences numériques I_{2log}(n) et Q_{2log}(n) produites par la voie "log", les signaux numériques S'_{I}(n) et S'_{Q}(n) utilisés par la chaine de synthèse 31 de synthétiser le signal de retour S'(t).

Dans une version alternative, la synthèse du signal de retour S'(t) prend en compte également les séquences ε_{1I}(n) et ε_{1Q}(n) correspondant aux signaux ε_{I}(n) et ε_{Q}(n), mémorisés durant l'intervalle de temps T précédant l'intervalle de temps courant considéré. On obtient ainsi, comme précédemment un signal de retour qui a déjà avantageusement subi une première correction.

ε_{I}(n) et ε_{Q}(n) ainsi obtenus représentent les composantes en phase et en quadrature du signal obtenu par application d'un filtrage passe bas du deuxième ordre au signal d'entrée S(t). En pratique, dans le cas du traitement de signaux radar, le signal ainsi obtenu correspond, comme pour l'application précédente au signal d'entrée dans lequel les échos fixes ont été supprimés, de manière plus sélective cependant. L'application illustrée par la figure 8 correspond donc à également à l'implémentation d'une fonction de type "visualisation des cibles mobiles" ou "MTI" ("Moving Target Indicator" selon la dénomination anglo-saxonne) au moyen du dispositif selon l'invention.

Tel qu'il a été présenté dans le texte qui précède, le dispositif selon l'invention est décrit dans une structure adaptée à la numérisation d'un signal d'entré en fréquence intermédiaire, sur lequel il est possible de réaliser une détection amplitude phase de façon à obtenir deux signaux en quadrature en bande de base. La figure 9 permet de mettre en évidence le fait que la structure générale du dispositif selon l'invention, telle qu'illustrée par la figure 1, est cependant naturellement applicable à la numérisation d'un signal hyperfréquence. Le signal de retour S'(t) est dans ce cas obtenu comme décrit précédemment et transposé en hyperfréquence 91 de façon à pouvoir être soustrait du signal d'entrée S(t) avant toute transposition, au moyen d'un dispositif 92 de type coupleur par exemple. Le signal ainsi obtenu est un signal en bande de base (signal vidéo) qui peut faire ensuite l'objet d'un traitement en amplitude et en phase classique.

## Revendications

1. Dispositif pour réaliser la conversion analogique-numérique d'un signal radioélectrique S(t) en deux signaux numériques en quadrature de phase S_{I} (n) et S_{Q}(n), ledit signal radioélectrique S(t) étant un signal en fréquence intermédiaire, stationnaire au moins sur un nombre N de périodes d'acquisition successives de durée T, ledit dispositif comportant:
- des moyens (14) pour mémoriser, pour chacun des signaux S_{I}(n) et S_{Q} (n), N séquences numériques successives S_{kI}(n) et S_{kQ}(n);
- des moyens (31) pour produire un signal de retour S'(t) en fréquence intermédiaire à partir des N séquences successives S_{kI}(n) et S_{kQ}(n) mémorisées;
- des moyens (34) pour réaliser la différence entre ledit signal S(t) à convertir et le signal de retour S'(t);
- des moyens (21) pour réaliser une détection amplitude-phase du signal ε(t) et former deux signaux en bande de base ε_{I}(t) et ε_{Q}(t), en quadrature de phase,
- deux voies de numérisation comportant chacune des moyens (13) pour réaliser la somme des signaux ε_{I}(n) et ε_{Q}(n), produits par des moyens de numérisation (12) à partir des signaux ε_{I}(t) et ε_{Q}(t), et des signaux S_{1I}(n) et S_{1Q}(n); les voies de numérisation délivrant les signaux S_{I}(n) et S_{Q}(n).

2. Dispositif selon la revendication 1, dans lequel, les deux voies de numérisation comportent chacune des moyens (14) pour mémoriser, pour chacun des signaux S_{I}(n) et S_{Q}(n), les séquences S_{1I}(n) et S_{1Q}(n) correspondant aux signaux S_{I}(n) et S_{Q}(n) pour l'intervalle de temps précédant l'intervalle de temps courant; les moyens (31) étant configurés pour former le signal S'(t) à partir de S_{1I}(n) et S_{1Q}(n).

3. Dispositif pour réaliser la conversion analogique-numérique d'un signal radioélectrique S(t) en deux signaux numériques en quadrature de phase S_{I} (n) et S_{Q}(n), les deux voies de numérisation comportent chacune des moyens (14) pour mémoriser, pour chacun des signaux S_{I}(n) et S_{Q}(n), les séquences S_{1I}(n) et S_{1Q}(n) correspondant aux signaux S_{I}(n) et S_{Q}(n) pour l'intervalle de temps précédant l'intervalle de temps courant; les moyens (31) étant configurés pour former le signal S'(t) à partir de S_{1I}(n) et S_{1Q}(n), le signal S(t) étant un signal radioélectrique en fréquence intermédiaire, stationnaire au moins sur un nombre N de périodes d'acquisition successives de durée T, ledit dispositif comportant::
- des moyens (31) pour produire un signal de retour S'(t) en fréquence intermédiaire à partir de signaux S'_{I}(n) et S'_{Q}(n) formés à partir dudit signal S(t), mémorisé, sur N séquences successives, après détection amplitude phase et numérisation;
- des moyens (34) pour réaliser la différence ε(t) entre le signal S(t) à convertir et le signal de retour S'(t);
- des moyens (21) pour réaliser une détection amplitude-phase du signal ε(t) et former deux signaux en bande de base ε_{I}(t) et ε_{Q}(t), en quadrature de phase,
- deux voies de numérisation comportant chacune des moyens (13) pour réaliser la somme des signaux E_{I}(n) et ε_{Q}(n), produits par des moyens de numérisation (12) à partir des signaux ε_{I}(t) et ε_{Q}(t), et des signaux S'_{I}(n) et S'_{Q}(n);
les voies de numérisation délivrant les signaux S_{I}(n) et S_{Q}(n).

4. Dispositif selon la revendication 3, comportant en outre:
- des moyens (41) pour produire deux signaux numériques I_{log}(n) et Q_{log}
(n) en quadrature de phase à partir du signal S(t) par numérisation (44) des signaux I_{log}(t) et Q_{log}(t) obtenus par amplification logarithmique (42) et détection amplitude-phase (43);
- des moyens (14) pour mémoriser pour chacun des signaux I_{log}(n) et Q_{log}
(n), N séquences numériques successives I_{klog}(n) et Q_{klog}(n);
- des moyens (45) pour synthétiser des signaux numériques linéaires S'_{I}(n)
et S'_{Q}(n) en quadrature de phase partir des N séquences numériques successives I_{klog}(n) et Q_{klog}(n);
- des moyens (31) pour produire un signal de retour S'(t) en fréquence
intermédiaire à partir de signaux S'_{I}(n) et S'_{Q}(n);

5. Dispositif selon la revendication 3, comportant en outre:
- des moyens (51) pour produire deux signaux numériques I'(n) et Q' (n) en
quadrature de phase à partir du signal S(t) par numérisation (44) des signaux I'(t) et Q'(t) obtenus par amplification et écrêtage (53) du signal S(t)
puis détection amplitude-phase (43);
- des moyens (52) pour produire un signal numérique S_{log}(n), par numérisation (58) du signal S_{log}(t) obtenu par amplification logarithmique
(55) et détection d'amplitude (56, 57) du signal S(t);
- des moyens (14) pour mémoriser pour chacun des signaux I'(n), Q'(n) et S
_{log}(n), N séquences numériques successives I'ₖ(n), Q'ₖ(n) et S_{klog}(n);
- des moyens (54) pour synthétiser des signaux numériques linéaires S'_{I}(n)
et S'_{Q}(n) en quadrature de phase à partir des N séquences numériques successives I'ₖ(n), Q'ₖ(n) et S_{klog}(n).

6. Dispositif selon la revendication 3, dans lequel:
- les deux voies de numérisation étant configurées pour délivrer des
signaux ε_{I}(n) et ε_{Q}(n), elles comportent des moyens (14) pour mémoriser les séquences numériques à ε_{1I}(n) et ε_{1Q}(n) correspondant à l'intervalle de temps précédant l'intervalle de temps courant ;
- les moyens de mémorisation (14) associés aux moyens (41) pour produire deux signaux numériques I_{log}(n) et Q_{log}(n) en quadrature de phase à partir du signal S(t) étant configurés pour mémoriser une séquence numérique I_{log}(n) ou Q_{log}(n) correspondant à l'intervalle de temps précédant l'intervalle de temps courant; les moyens (71) pour synthétiser les signaux S'_{I}(n) et S'_{Q}(n) sont configurés pour synthétiser S'_{I}(n) et S'_{Q}(n) à partir des séquences numériques I_{log}(n) et Q_{log}(n) et des séquences numériques ε_{1I}(n) et ε_{1Q}(n), de sorte que le signal S'(t) synthétisé partir de S'_{I}(n) et S'_{Q}(n) corresponde S(t-T).

7. Dispositif selon la revendication 4, dans lequel:
- les deux voies de numérisation étant configurées pour délivrer des signaux ε_{I}(n) et ε_{Q}(n), elles comportent des moyens (14) pour mémoriser les séquences numériques à ε_{1I}(n) et ε_{1Q}(n) correspondant à l'intervalle de temps précédant l'intervalle de temps courant;
- les moyens de mémorisation (14) associés aux moyens (41) pour produire deux signaux numériques I_{log}(n) et Q_{log}(n) en quadrature de phase à partir du signal S(t) étant configurés pour mémoriser deux séquences numériques successives I_{1log}(n) ou Q_{1log}(n) et I_{2log}(n) ou Q_{2log}(n) correspondant aux deux intervalles de temps successifs précédant l'intervalle de temps courant; les moyens (81) pour synthétiser des signaux numériques linéaires S'_{I}(n) et S'_{Q}(n) en quadrature de phase sont configurés pour synthétiser S'_{I}(n) et S'_{Q}(n) partir des séquences numériques I_{1log}(n) et Q_{1log}(n) et des séquences I_{2log}(n) et Q_{2log}(n).

8. Dispositif selon la revendication 4, dans lequel:
- les deux voies de numérisation étant configurées pour délivrer les signaux ε_{I}(n) et ε_{Q}(n), elles comportent:
- des moyens (14) pour mémoriser les séquences numériques ε_{1I}(n) et ε_{1Q}(n) correspondant l'intervalle de temps précédant l'intervalle de temps courant;
- des moyens (82) pour réaliser la somme du signal I_{log}(n) après une première mémorisation avec le signal ε_{1I}(n) et la somme du signal Q_{log}(n) après une première mémorisation avec le signal ε_{1Q}(n), les signaux sommes obtenus étant mémorisés pour former des signaux I_{2log}(n) et Q_{2log}(n);
- les moyens (81) pour synthétiser des signaux numériques linéaires S'_{I}(n) et S'_{Q}(n) en quadrature de phase sont configurés pour synthétiser S'_{I}(n) et S'_{Q}(n) partir des séquences numériques I_{1log}(n) et Q_{1log}(n) et des séquences I_{2log}(n) et Q_{2log}(n)).

9. Dispositif selon l'une quelconque des revendications 1 à 8, dans lequel, les moyens (31) pour produire un signal de retour S'(t) en fréquence intermédiaire à partir de signaux S'I(n) et S'Q(n) comportent:
- des moyens (32) pour générer à partir d'un oscillateur local un signal S'(t) d'amplitude et de phase données;
- des moyens (33) pour générer des signaux de commande permettant de contrôler l'amplitude et la phase du signal S'(t) généré; Les signaux de commande générés étant fonctions des signaux S'_{I}(n) et S'_{Q}(n).

10. Dispositif selon la revendication 9 ,dans lequel, les moyens (32) pour générer le signal S'(t) à partir d'un oscillateur local comportent un amplificateur a gain variable (322) et un circuit déphaseur (321).

11. Dispositif selon la revendication 9, dans lequel, les moyens pour générer le signal S'(t) à partir d'un oscillateur local comportent un circuit (61) de synthèse directe de fréquence.

## Patentansprüche

1. Vorrichtung zum Durchführen der Analog-Digital-Umwandlung eines Funksignals S(t) in zwei Digitalsignale S_{I}(n) und S_{Q}(n) in Phasenquadratur, wobei das Funksignal S(t) ein Zwischenfrequenzsignal ist, das wenigstens auf einer Anzahl N von aufeinander folgenden Erfassungsperioden der Dauer T stationär ist, wobei die Vorrichtung Folgendes umfasst:
- Mittel (14) zum Speichern, für jedes der Signale S_{I}(n) und S_{Q}(n), von N aufeinander folgenden digitalen Sequenzen S_{kI}(n) und S_{kQ}(n);
- Mittel (31) zum Produzieren eines Zwischenfrequenzrückkehrsignals S'(t) auf der Basis der gespeicherten N aufeinander folgenden Sequenzen S_{kI}(n) und S_{kQ}(n);
- Mittel (34) zum Ermitteln der Differenz ε(t) zwischen dem umzuwandelnden Signal S(t) und dem Rückkehrsignal S'(t);
- Mittel (21) zum Realisieren einer Amplitude-Phase-Erkennung des Signals ε(t) und Bilden von zwei Basisbandsignalen ε_{I}(t) und ε_{Q}(t) in Phasenquadratur,
- zwei Digitalisierungskanäle, die jeweils Mittel (13) zum Ermitteln der Summe der Signale ε_{I}(n) und ε_{Q}(n) umfassen, produziert von Digitalisierungsmitteln (12) auf der Basis der Signale ε_{I}(t) und ε_{Q}(t) und der Signale S_{1I}(n) und S_{1Q}(n); wobei die Digitalisierungskanäle die Signale S_{I}(n) und S_{Q}(n) liefern.

2. Vorrichtung nach Anspruch 1, bei der die zwei Digitalisierungskanäle jeweils Mittel (14) zum Speichern, für jedes der Signale S_{I}(n) und S_{Q}(n), der Sequenzen S_{1I}(n) und S_{1Q}(n) entsprechend den Signalen S_{I}(n) und S_{Q}(n) für das Zeitintervall umfassen, das dem laufenden Zeitintervall vorangeht; wobei die Mittel (31) zum Bilden des Signals S'(t) auf der Basis von S_{1I}(n) und S_{1Q}(n) konfiguriert sind.

3. Vorrichtung zum Durchführen der Analog-Digital-Umwandlung eines Funksignals S(t) in zwei Digitalsignale S_{I}(n) und S_{Q}(n) in Phasenquadratur, wobei die beiden Digitalisierungskanäle jeweils Mittel (14) zum Speichern, für jedes der Signale S_{I}(n) und S_{Q}(n), der Sequenzen S_{1I}(n) und S_{1Q}(n) entsprechend den Signalen S_{I}(n) und S_{Q}(n) für das Zeitintervall umfassen, das dem laufenden Zeitintervall vorangeht; wobei die Mittel (31) zum Bilden des Signals S'(t) auf der Basis von S_{1I}(n) und S_{1Q}(n) konfiguriert sind; wobei das Signal S(t) ein Zwischenfrequenzfunksignal ist, das auf wenigstens einer Anzahl N von aufeinander folgenden Erfassungsperioden der Dauer T stationär ist, wobei die Vorrichtung Folgendes umfasst:
- Mittel (31) zum Produzieren eines Zwischenfrequenzrückkehrsignals S'(t) auf der Basis von Signalen S'_{I}(n) und S'_{Q}(n), gebildet auf der Basis des gespeicherten Signals S(t), auf N aufeinander folgenden Sequenzen, nach Amplitude-Phase-Erkennung und Digitalisierung;
- Mittel (34) zum Ermitteln der Differenz ε(t) zwischen dem umzuwandelnden Signal S(t) und dem Rückkehrsignal S'(t);
- Mittel (21) zum Durchführen einer Amplitude-Phase-Erkennung des Signals ε(t) und Bilden von zwei Basisbandsignalen ε_{I}(t) und ε_{Q}(t) in Phasenquadratur,
- zwei Digitalisierungskanäle, die jeweils Mittel (13) zum Ermitteln der Summe der Signale E_{I}(n) und ε_{Q}(n) umfassen, produziert durch Digitalisierungsmittel (12) auf der Basis der Signale ε_{I}(t) und ε_{Q}(t) und der Signale S'_{I}(n) und S'_{Q}(n);
wobei die Digitalisierungskanäle die Signale S_{I}(n) und S_{Q}(n) liefern.

4. Vorrichtung nach Anspruch 3, die ferner Folgendes umfasst:
- Mittel (41) zum Produzieren von zwei Digitalsignalen I_{log}(n) und Q_{log}(n) in Phasenquadratur auf der Basis des Signals S(t) durch Digitalisieren (44) der Signale I_{log}(t) und Q_{log}(t), erhalten durch logarithmische Verstärkung (42) und Amplitude-Phase-Erkennung (43);
- Mittel (14) zum Speichern, für jedes der Signale I_{log}(n) und Q_{log}(n), von N aufeinander folgenden digitalen Signalen I_{klog}(n) und Q_{klog}(n);
- Mittel (45) zum Synthetisieren der linearen digitalen Signale S'_{I}(n) und S'_{Q}(n) in Phasenquadratur auf der Basis der N aufeinander folgenden digitalen Sequenzen I_{klog}(n) und Q_{klog}(n);
- Mittel (31) zum Produzieren eines Zwischenfrequenzrückkehrsignals S'(t) auf der Basis der Signale S'_{I}(n) und S'_{Q}(n).

5. Vorrichtung nach Anspruch 3, die ferner Folgendes umfasst:
- Mittel (51) zum Produzieren von zwei digitalen Signalen I'(n) und Q'(n) in Phasenquadratur auf der Basis des Signals S(t) durch Digitalisieren (44) der Signale I'(t) und Q'(t), erhalten durch Verstärken und Begrenzen (53) des Signals S(t), dann Amplitude-Phase-Erkennung (43);
- Mittel (52) zum Produzieren eines digitalen Signals S_{log}(n) durch Digitalisieren (58) des Signals S_{log}(t), erhalten durch logarithmisches Verstärken (55) und Amplitudenerkennung (56, 57) des Signals S(t);
- Mittel (14) zum Speichern, für jedes der Signale I'(n), Q'(n) und S_{log}(n), von N aufeinander folgenden digitalen Sequenzen I'ₖ(n), Q'ₖ(n) und S_{klog}(n);
- Mittel (54) zum Synthetisieren der linearen digitalen Signale S'_{I}(n) und S'_{Q}(n) in Phasenquadratur auf der Basis der N aufeinander folgenden digitalen Sequenzen I'ₖ(n), Q'ₖ(n) und S_{klog}(n).

6. Vorrichtung nach Anspruch 3, bei der:
- da die beiden Digitalisierungskanäle zum Liefern der Signale ε_{I}(n) und ε_{Q}(n) konfiguriert sind, sie Mittel (14) zum Speichern der digitalen Sequenzen zu ε_{1I}(n) und ε_{1Q}(n) entsprechend dem Zeitintervall umfassen, das dem laufenden Zeitintervall vorangeht;
- die Speichermittel (14), die mit den Mitteln (41) zum Produzieren von zwei digitalen Signalen I_{log}(n) und Q_{log}(n) in Phasenquadratur auf der Basis des Signals S(t) assoziiert sind, zum Speichern einer digitalen Sequenz I_{log}(n) oder Q_{log}(n) entsprechend dem Zeitintervall konfiguriert sind, das dem laufenden Zeitintervall vorangeht;
die Mittel (71) zum Synthetisieren der Signale S'_{I}(n) und S'_{Q}(n) zum Synthetisieren von S'_{I}(n) und S'_{Q}(n) auf der Basis der digitalen Sequenzen I_{log}(n) und Q_{log}(n) und der digitalen Sequenzen ε_{1I}(n) und ε_{1Q}(n) konfiguriert sind, so dass das auf der Basis von S'_{I}(n) und S'_{Q}(n) synthetisierte Signal S'(t) S(t-T) entspricht.

7. Vorrichtung nach Anspruch 4, bei der:
- da die zwei Digitalisierungskanäle zum Liefern der Signale ε_{I}(n) und ε_{Q}(n) konfiguriert sind, sie Mittel (14) zum Speichern der digitalen Sequenzen zu ε_{1I}(n) und ε_{1Q}(n) entsprechend dem Zeitintervall umfassen, das dem laufenden Zeitintervall vorangeht;
- die mit den Mitteln (41) zum Produzieren von zwei digitalen Signalen I_{log}(n) und Q_{log}(n) in Phasenquadratur auf der Basis des Signals S(t) assoziierten Speichermittel (14) zum Speichern von zwei aufeinander folgenden digitalen Sequenzen I_{1log}(n) oder Q_{1log}(n) und I_{2log}(n) oder Q_{2log}(n) entsprechend zwei aufeinander folgenden Zeitintervallen konfiguriert sind, die dem laufenden Zeitintervall vorangehen; wobei die Mittel (81) zum Synthetisieren der linearen digitalen Signale S'_{I}(n) und S'_{Q}(n) in Phasenquadratur zum Synthetisieren von S'_{I}(n) und S'_{Q}(n) auf der Basis der digitalen Sequenzen I_{1log}(n) und Q_{1log}(n) und der Sequenzen I_{2log}(n) und Q_{2log}(n) konfiguriert sind.

8. Vorrichtung nach Anspruch 4, bei der:
- da die zwei Digitalisierungskanäle zum Liefern der Signale ε_{I}(n) und ε_{Q}(n) konfiguriert sind, sie Folgendes umfassen:
- Mittel (14) zum Speichern der digitalen Sequenzen ε_{1I}(n) und ε_{1Q}(n) entsprechend dem Zeitintervall, das dem laufenden Zeitintervall vorangeht;
- Mittel (82) zum Summieren des Signals I_{log}(n) nach einer ersten Speicherung mit dem Signal ε_{1I}(n) und zum Summieren des Signals Q_{log}(n) nach einer ersten Speicherung mit dem Signal S_{1Q}(n), wobei die erhaltenen summierten Signale zum Bilden der Signale I_{2log}(n) und Q_{2log}(n) gespeichert werden;
- wobei die Mittel (81) zum Synthetisieren der linearen digitalen Signale S'_{I}(n) und S'_{Q}(n) in Phasenquadratur zum Synthetisieren von S'_{I}(n) und S'_{Q}(n) auf der Basis der digitalen Sequenzen I_{1log}(n) und Q_{1log}(n) und der Sequenzen I_{2log}(n) und Q_{2log}(n) konfiguriert sind.

9. Vorrichtung nach einem der Ansprüche 1 bis 8, bei der die Mittel (31) zum Produzieren eines Zwischenfrequenzrückkehrsignals S'(t) auf der Basis der Signale S'_{I}(n) und S'_{Q}(n) Folgendes umfassen:
- Mittel (32) zum Erzeugen, auf der Basis eines Lokaloszillators, eines Signals S'(t) mit gegebener Amplitude und Phase;
- Mittel (33) zum Erzeugen von Steuersignalen, die das Regeln von Amplitude und Phase des erzeugten Signals S'(t) zulassen, wobei die erzeugten Steuersignale von den Signalen S'_{I}(n) und S'_{Q}(n) abhängig sind.

10. Vorrichtung nach Anspruch 9, bei der die Mittel (32) zum Erzeugen des Signals S'(t) auf der Basis eines Lokaloszillators einen Verstärker (322) mit veränderlicher Verstärkung und eine Phasenschieberschaltung (321) umfassen.

11. Vorrichtung nach Anspruch 9, bei der die Mittel zum Erzeugen des Signals S'(t) auf der Basis eines Lokaloszillators eine Frequenzdirektsyntheseschaltung (61) umfassen.

## Claims

1. A device for performing the analogue-digital conversion of a radio signal S(t) into two digital phase quadrature signals S_{I}(n) and S_{Q}(n), said radio signal S(t) being an intermediate frequency signal that is stationary at least over a number N of successive acquisition periods of duration T, said device comprising:
- means (14) for storing, for each of the signals S_{I}(n) and S_{Q}(n), N successive digital sequences S_{kI}(n) and S_{kQ}(n);
- means (31) for producing an intermediate frequency return signal S'(t) based on the N stored successive sequences S_{kI}(n) and S_{kQ}(n);
- means (34) for determining the difference ε(t) between said signal S(t) to be converted and the return signal S'(t);
- means (21) for performing a phase-amplitude detection of the signal ε(t) and for forming two phase quadrature baseband signals ε_{I}(t) and ε_{Q}(t);
- two digitisation channels each comprising means (13) for adding the sum of the signals ε_{I}(n) and ε_{Q}(n) which are produced by digitisation means (12) based on the signals ε_{I}(t) and ε_{Q}(t), and the signals Sn(n) and S_{IQ}(n), the digitisation channels delivering the signals S_{I}(n) and S_{Q}(n).

2. The device as claimed in claim 1, wherein the two digitisation channels each comprise means (14) for storing, for each of the signals S_{I}(n) and S_{Q}(n), the sequences Sn(n) and S_{1Q}(n) corresponding to the signals S_{I}(n) and S_{Q}(n) for the time interval preceding the current time interval, the means (31) being configured to form the signal S'(t) based on S_{1I}(n) and S_{1Q}(n).

3. A device for performing the analogue-digital conversion of a radio signal S(t) into two phase quadrature digital signals S_{I}(n) and S_{Q}(n), the two digitisation channels each comprising means (14) for storing, for each of the signals S_{I}(n) and S_{Q}(n), the sequences Sn(n) and S_{1Q}(n) corresponding to the signals S_{I}(n) and S_{Q}(n) for the time interval preceding the current time interval, the means (31) being configured to form the signal S'(t) based on S_{1I}(n) and S_{1Q}(n) the signal S(t) being an intermediate frequency radio signal that is stationary at least over a number N of successive acquisition periods of duration T, said device comprising:
- means (31) for producing an intermediate frequency return signal S'(t) based on signals S'_{I}(n) and S'_{Q}(n) formed based on said signal S(t) that is stored, over N successive sequences, after phase amplitude detection and digitisation;
- means (34) for determining the difference ε(t) between the signal S(t) to be converted and the return signal S'(t);
- means (21) for performing a phase-amplitude detection of the signal ε(t) and for forming two phase quadrature baseband signals ε_{I}(t) and ε_{Q}(t);
- two digitisation channels each comprising means (13) for adding the sum of the signals ε_{I}(n) and ε_{Q}(n), which are produced by digitisation means (12) based on the signals ε_{I}(t) and ε_{Q}(t), and the signals S'_{I}(n) and S'_{Q}(n);
- the digitisation channels delivering the signals S_{I}(n) and S_{Q}(n).

4. The device as claimed in claim 3, further comprising:
- means (41) for producing two digital phase quadrature signals I_{log}(n) and Q_{log}(n) based on the signal S(t) by digitising (44) signals I_{log}(t) and Q_{log}(t) obtained by logarithmic amplification (42) and amplitude-phase detection (43);
- means (14) for storing, for each of the signals I_{log}(n) and Q_{log}(n), N successive digital sequences I_{klog}(n) and Q_{klog}(n);
- means (45) for synthesising linear digital phase quadrature signals S'_{I}(n) and S'_{Q}(n) based on the N successive digital sequences I_{klog}(n) and Q_{klog}(n);
- means (31) for producing an intermediate frequency return signal S'(t) based on the signals S'_{I}(n) and S'_{Q}(n).

5. The device as claimed in claim 3, further comprising:
- means (51) for producing two digital phase quadrature signals I'(n) and Q'(n) based on the signal S(t) by digitising (44) the signals I'(t) and Q'(t) obtained by amplification and clipping (53) of the signal S(t), then amplitude-phase detection (43);
- means (52) for producing a digital signal S_{log}(n), by digitising (58) the signal S_{log}(t) obtained by logarithmic amplification (55) and amplitude detection (56, 57) of the signal S(t);
- means (14) for storing, for each of the signals I'(n), Q'(n) and S_{log}(n), N successive digital sequences I'ₖ (n), Q'ₖ(n) and S_{klog}(n);
- means (54) for synthesising linear digital phase quadrature signals S'_{I}(n) and S'_{Q}(n) based on the N successive digital sequences I'ₖ(n), Q'ₖ(n) and S_{klog}(n).

6. The device as claimed in claim 3, wherein:
- with the two digitisation channels being configured to deliver the signals ε_{I}(n) and ε_{Q}(n) they comprise means (14) for storing the digital sequences ε_{1I}(n) and ε_{1Q}(n) corresponding to the time interval preceding the current time interval;
- the storage means (14) associated with the means (41) for producing two digital phase quadrature signals I_{log}(n) and Q_{log}(n) based on the signal S(t) being configured to store a digital sequence I_{log}(n) or Q_{log}(n) corresponding to the time interval preceding the current time interval;
the means (71) for synthesising the signals S'_{I}(n) and S'_{Q}(n) are configured to synthesise S'_{I}(n) and S'_{Q}(n) based on the digital sequences I_{log}(n) and Q_{log}(n) and the digital sequences ε_{1I}(n) and ε_{1Q}(n) so that the signal S'(t) synthesised based on S'_{I}(n) and S'_{Q}(n) corresponds to S(t-T).

7. The device as claimed in claim 4, wherein:
- with the two digitisation channels being configured to deliver the signals ε_{I}(n) and ε_{Q}(n), they comprise means (14) for storing the digital sequences ε_{1I}(n) and ε_{1Q}(n) corresponding to the time interval preceding the current time interval;
- the storage means (14) associated with the means (41) for producing two digital phase quadrature signals I_{log}(n) and Q_{log}(n) based on the signal S(t) being configured to store two successive digital sequences I_{1log}(n) or Q_{1log}(n) and I_{2log}(n) or Q_{2log}(n) corresponding to the two successive time intervals preceding the current time interval; the means (81) for synthesising the linear digital phase quadrature signals S'_{I}(n) and S'_{Q}(n) are configured to synthesise S'_{I}(n) and S'_{Q}(n) based on the digital sequences I_{1log}(n) and Q_{1log}(n) and the sequences I_{2log}(n) and Q_{2log}(n).

8. The device as claimed in claim 4, wherein:
- with the two digitisation channels being configured to deliver the signals ε_{I}(n) and ε_{Q}(n) they comprise:
- means (14) for storing the digital sequences ε_{1I}(n) and ε_{1Q}(n) corresponding to the time interval preceding the current time interval;
- means (82) for adding the sum of the signal I_{log}(n) following a first storage process with the signal ε_{1I}(n) and the sum of the signal Q_{log}(n) following a first storage process with the signal S_{1Q}(n), the obtained signal sums being stored to form the signals I_{2log}(n) and Q_{2log}(n);
- the means (81) for synthesising the linear digital phase quadrature signals S'_{I}(n) and S'_{Q}(n) are configured to synthesise S'_{I}(n) and S'_{Q}(n) based on the digital sequences I_{1log}(n) and Q_{1log}(n) and the sequences I_{2log}(n) and Q_{2log}(n).

9. The device as claimed in any one of claims 1 to 8, wherein the means (31) for producing an intermediate frequency return signal S'(t) based on signals S'_{I}(n) and S'_{Q}(n) comprise:
- means (32) for generating a signal S'(t) with given amplitude and phase based on a local oscillator;
- means (33) for generating control signals allowing the amplitude and the phase of the generated signal S'(t) to be controlled, the generated control signals being functions of the signals S'_{I}(n) and S'_{Q}(n).

10. The device as claimed in claim 9, wherein the means (32) for generating the signal S'(t) based on a local oscillator comprise a variable gain amplifier (322) and a phase shifting circuit (321).

11. The device as claimed in claim 9, wherein the means for generating the signal S'(t) based on a local oscillator comprise a direct frequency synthesis circuit (61).
